# DEMANDE DE BREVET EUROPEEN

(11) **EP 4 177 452 A1**
(43) Date de publication de la demande: **10.05.2023**
(21) Numéro de dépôt: 22216760.3
(22) Date de dépôt: 06.05.2013
(51) Int. Cl.: F02F 1/00, C23C 16/00

(54) **CHEMISE DE MOTEUR À COMBUSTION INTERNE**

(30) Priorité: 03.05.2012 FR 1254060
(62) Demande divisionnaire de: 13729417.9
(71) Demandeur: HYDROMECANIQUE ET FROTTEMENT, 42160 Andrézieux-Bouthéon (FR)
(72) Inventeur: HEAU, Christophe, 42650 SAINT-JEAN-BONNEFONDS (FR); BOMBILLON, Laurent, 42160 ANDREZIEUX BOUTHEON (FR); MAURIN-PERRIER, Philippe, 42680 SAINT MARCELLIN EN FOREZ (FR)
(74) Mandataire: Cabinet Laurent & Charras

(57) **Abrégé**

L'intérieur de la dite chemise est traité pour être totalement lisse et reçoit un revêtement du type DLC.

## Description

L'invention concerne une chemise de moteur à combustion interne.

Plus particulièrement, l'invention concerne un traitement d'une chemise de moteur à combustion interne ou objet de géométrie similaire avec, pour objectif, de réduire les pertes par frottement. L'invention trouve une application particulièrement avantageuse et non limitative au le domaine de l'automobile.

Il est parfaitement connu pour un homme du métier d'utiliser des revêtements du type DLC (*Diamond Like Carbon*) sur segments afin d'abaisser le coefficient de frottement de la plupart des métaux. C'est par exemple le cas pour les ensembles segments, pistons, chemises d'un moteur à combustion interne où les frottements peuvent générer environ 30 à 40 % des pertes du moteur.

Pour tenter de réduire le coefficient de frottement, on a proposé d'appliquer un revêtement de type DLC sur les segments, comme il ressort par exemple de l'enseignement du document WO 2011/051008. Cette solution n'est toutefois pas satisfaisante.

On rappelle, d'un point de vue cinématique, qu'un segment subit une usure plus importante qu'une chemise. En effet, un point du segment est en contact permanent avec la chemise lors d'un cycle aller-retour du piston, tandis qu'un point de la chemise est en contact avec le segment sur un instant très court.

En outre, pour obtenir un résultat satisfaisant, il est nécessaire d'appliquer un revêtement DLC d'une épaisseur très importante, généralement supérieure à 10 µm, ce qui représente un inconvénient sur le plan économique et des difficultés importantes sur un plan technique.

En effet, l'épaisseur importante de la couche de DLC génère une rugosité importante sur le segment nécessitant une reprise après dépôt sans quoi l'usure de la chemise ne serait pas acceptable. On observe également que le segment atteint des températures importantes potentiellement nuisibles au revêtement DLC.

Comme indiqué, l'usure étant moins importante dans le cas de la chemise, on a proposé d'intervenir au niveau de la surface interne de la chemise pour tenter de réduire les frottements.

Dans ce but, selon l'enseignement de l'état de la technique, la chemise moteur subit une opération de finition consistant à créer des motifs en creux ayant pour fonction de conserver du lubrifiant dans le contact mécanique considéré. Cette opération de finition, connue sous le nom de « honing », est appliquée soit directement dans la chemise soit dans un revêtement épais appliqué à l'intérieur de ladite chemise. Ce type de solution ressort par exemple de l'enseignement du brevet EP 0716151 qui concerne une chemise dont l'intérieur présente un dépôt épais réalisé par projection thermique, puis soumis à l'étape de honing qui enlève jusqu'à 10 µm d'épaisseur de dépôt.

On peut citer également le document WO 2009106981 qui fait référence à une étape de honing effectuée après application du revêtement.

Il ressort donc de l'état de la technique que les solutions utilisées pour tenter de réduire le frottement au niveau des chemises et limiter les risques de grippage, nécessitent toutes une étape de finition mécanique (honing) nécessaire à la création de zones en relief afin de conserver le lubrifiant dans le contact mécanique considéré, par exemple entre le segment et la chemise.

Ces solutions nécessitent d'avoir une quantité d'huile importante sur les parois de la chemise. Une partie de l'énergie est perdue dans le cisaillement du film.

L'invention s'est fixée pour but de remédier à ces inconvénients de manière simple, sûre, efficace et rationnelle.

Le problème que se propose de résoudre l'invention est de supprimer l'opération de finition à l'intérieur de la chemise (honing) afin de minimiser la quantité d'huile sur la paroi de la chemise et réduire les efforts perdus dans le cisaillement du film d'huile.

Le but recherché est également de réduire l'usure des segments afin de conserver une étanchéité optimale de la segmentation au cours de la durée de vie du moteur.

Pour résoudre un tel problème, il a été conçu et mis au point une chemise de moteur à combustion interne notamment, dont l'intérieur est traité pour être totalement lisse pour recevoir un revêtement de type DLC.

Il résulte de ces caractéristiques que l'utilisation d'une chemise entièrement lisse, par exemple polie, et revêtue de DLC, permet de réduire, de manière significative, les pertes par frottement du segment du piston contre la chemise et, indirectement, de réduire les émissions de CO₂ du moteur. L'utilisation d'une rugosité basse permet également de réduire l'usure du segment et, par conséquent, de maintenir un haut niveau de performance pendant la durée de vie du moteur (taux de compression ou consommation d'huile). Enfin, l'utilisation d'un revêtement DLC à l'intérieur de la chemise permet de s'affranchir de l'étape finale de honing avec les inconvénients en résultant.

La rugosité Ra de la surface de la chemise avant dépôt est inférieure à 0,06 µm et avantageusement inférieure à 0,04 µm.

Avantageusement, l'épaisseur totale du revêtement comportant la couche de DLC est inférieure à 10 µm et de préférence inférieure à 7 µm et avantageusement inférieure ou égale à 4 µm.

La chemise moteur est réalisée dans un matériau de type métallique apte à subir une opération de polissage pour obtenir une faible rugosité. A titre indicatif, nullement limitatif, la chemise est réalisée dans un alliage d'aluminium, en acier, en acier inoxydable ...

Le revêtement DLC est appliqué à l'intérieur de la chemise en mettant en oeuvre soit un procédé spécialement adapté lorsque la longueur de ladite chemise est supérieure à son diamètre, soit un procédé plus conventionnel lorsque la longueur de ladite chemise est inférieure ou de l'ordre de grandeur de son diamètre. Par exemple, le revêtement DLC est appliqué à l'intérieur de la chemise par la technique de dépôt sous vide comportant, de manière connue, une étape de décapage ionique et une étape correspondant au dépôt en tant que telle.

Le décapage ionique consiste à pulvériser la surface à partir d'ions massifs. Les atomes de surface sont éjectés de sorte que l'on enlève l'oxyde superficiel nuisible à l'adhérence d'un dépôt. Le décapage de l'oxyde superficiel n'apporte aucune modification de l'état de surface. Quant au dépôt, ce dernier consiste à craquer un hydrocarbure tel que de l'acétylène, du méthane, ... qui se condense à la surface des pièces pour former un revêtement de DLC. Pour permettre l'accroche du DLC, on utilise, au préalable, une sous-couche apte à former un dépôt adhérent au matériau constitutif de la chemise et sur lequel le DLC adhère. Cette sous-couche, peut être déposée par technique de dépôt PVD ou par technique de dépôt PACVD. Les difficultés liées au traitement de l'intérieur de la chemise ou organe équivalent concernent l'homogénéité du plasma et du traitement en résultant. Le plasma peut être créé par polarisation de la chemise ou bien à partir d'une source plasma auxiliaire placée à l'intérieur ou à l'extérieur de la chemise selon sa géométrie, c'est-à-dire sa longueur par rapport à son diamètre.

L'invention est exposée ci-après plus en détail à l'aide des différents exemples et formes de réalisation en considérant l'application d'un revêtement DLC à l'intérieur d'une chemise entièrement polie selon les caractéristiques de l'invention et à l'intérieur d'une chemise ayant subi une opération de honing, selon l'état de la technique.

Dans une première forme de réalisation, deux chemises moteur en acier, de 72 mm de diamètre et 150 mm de long ont été revêtues de DLC. La surface interne d'une des chemises a été, selon l'invention, préalablement polie par technique de type tribofinition, de sorte que le Ra soit inférieur à 0,02 µm. La deuxième chemise moteur a subi une opération de honing, telle que réalisée selon l'état de l'art. Le Ra de cette deuxième chemise est de 0,25 µm, elle présente un RSk négatif. La valeur négative du RSk indique la présence des stries du honing.

Après nettoyage, les chemises ont été placées dans une enceinte à vide. Pendant le pompage, la chambre à vide et les chemises sont dégazées de façon conventionnelle par chauffage radiatif à 200°C. Lorsque le vide a atteint une pression de l'ordre de 1×10⁻⁵ mbar, de l'argon a été introduit dans la chambre à vide pour obtenir une pression de 1 Pa et les chemises ont été portées à une haute tension négative de -500 V pour effectuer un décapage ionique, permettant d'éliminer l'oxyde naturel recouvrant l'acier pour favoriser l'adhérence du revêtement. Après décapage, un dépôt de type carbure de tungstène a été effectué à l'intérieur de chacune des chemises en utilisant une cathode magnétron cylindrique de 30 mm de diamètre, placée à l'intérieur de la chemise. La cible utilisée pour ce dépôt, est en carbure de tungstène. La densité de puissance appliquée à la cathode est de l'ordre de 5W/cm².En cours de dépôt de carbure de tungstène, de l'acétylène a été introduit à débit croissant de sorte que la structure du dépôt évolue d'un carbure de tungstène à une matrice de carbone amorphe incluant du tungstène. Enfin, la couche de carbone amorphe de type DLC est déposée en portant la pièce à une tension de -450V dans une atmosphère d'acétylène à une pression de 0,9 Pa.

Il résulte de ces opérations un dépôt de type DLC à l'intérieur de chaque chemise, qui se caractérise par une adhérence par indentation Rockwell, notée HF1 à HF3. L'épaisseur du dépôt, déterminée par calotest, indique que la sous-couche a une épaisseur de 0,7 µm et le DLC une épaisseur de 2,5 µm.

Dans une seconde réalisation conforme, deux chemises moteur en acier, de 72 mm de diamètre et 150 mm de long ont été revêtues de DLC. La surface interne de la première chemise a été, selon l'invention, préalablement polie par technique de type bufflage, consistant à faire tourner dans la chemise des disques de tissus imprégnés de pâte abrasive, de sorte que le Ra soit inférieur à 0,04 µm. La deuxième chemise moteur a subi une opération de honing, telle que réalisée selon l'état de l'art, son Ra est de 0,25 µm.

Après nettoyage, les chemises ont été placées dans une enceinte à vide. Pendant le pompage, la chambre à vide et la chemise sont dégazées de façon conventionnelle par chauffage radiatif à 200°C. Lorsque le vide a atteint une pression de l'ordre de 1×10⁻⁵ mbar, de l'argon a été introduit dans la chambre à vide pour obtenir une pression de 1 Pa et les chemises ont été portées à une haute tension négative de -500 V pour effectuer un décapage ionique, permettant d'éliminer l'oxyde naturel recouvrant l'acier pour favoriser l'adhérence du revêtement. Après décapage, un dépôt de type carbure de chrome a été effectué à l'intérieur de chaque chemise en utilisant une cathode magnétron cylindrique de 30 mm de diamètre, placée à l'intérieur de la chemise. Dans cet exemple, la cathode magnétron cylindrique est recouverte d'une cible de carbure de chrome, à laquelle on applique une densité de puissance de 5 W/cm². En cours de dépôt de carbure de chrome, de l'acétylène a été introduit à débit croissant de sorte que la structure du dépôt évolue d'un carbure de chrome à une matrice de carbone amorphe incluant du chrome. Enfin, la couche de carbone amorphe de type DLC est déposée en portant la pièce à une tension de -450V dans une atmosphère d'acétylène à une pression de 0,9 Pa.

Il résulte de ces opérations un dépôt de type DLC à l'intérieur de chaque chemise, qui se caractérise par une adhérence par indentation Rockwell, notée HF1 à HF3. L'épaisseur du dépôt, déterminée par calotest, indique que la sous-couche a une épaisseur de 0,8 µm et le DLC une épaisseur de 2,7 µm.

Dans une troisième réalisation conforme, deux chemises moteur en acier inoxydable, de 86 mm de diamètre et 150 mm de long ont été revêtues de DLC. La surface interne de la première chemise a été préalablement polie par technique de polissage électrolytique, de sorte que le Ra soit inférieur à 0,03 µm. La deuxième chemise moteur a subi une opération de honing, telle que réalisée selon l'état de l'art, donnant un Ra de 0,25 µm.

La suite du procédé est identique à la seconde réalisation.

Il résulte de ces opérations un dépôt de type DLC à l'intérieur de chaque chemise, qui se caractérise par une adhérence par indentation Rockwell, notée HF1 à HF3. L'épaisseur du dépôt, déterminée par calotest, indique que la sous-couche a une épaisseur de 0,8 µm et le DLC une épaisseur de 2,7 µm.

Dans une quatrième réalisation conforme de l'invention, deux chemises moteur en acier de 92 mm de diamètre interne et 88 mm de long ont été revêtues de DLC. La surface interne de la première chemise a subi un polissage par toilage permettant d'obtenir une rugosité inférieure à 0,03 µm. La longueur de la chemise, en regard de son diamètre intérieur permet d'utiliser une technique de dépôt plus conventionnelle, à savoir que les sources de plasma sont placées à l'extérieur de la chemise. La deuxième chemise moteur a subi une opération de honing, telle que réalisée selon l'état de l'art, son Ra est de 0,25 µm.

Après nettoyage des chemises, ces dernières sont positionnées sur un montage mécanique, permettant aux chemises de tourner sur elles-mêmes et dans la machine, selon un mouvement planétaire, permettant au traitement de pénétrer par les 2 extrémités de la chemise. Après dégazage de la machine à vide par chauffage à 200°C, les chemises sont décapées dans une atmosphère d'argon à une pression de 0,3 Pa. Le décapage est réalisé en portant les chemises à une tension de -150V par rapport aux parois de la machine. Le plasma d'argon est réalisé à partir d'un système micro-onde ECR, à une puissance de 350W. Le décapage est suivi du dépôt d'une couche mince de chrome de 0,1 à 0,2 µm d'épaisseur, élaboré à partir de cathodes magnétron planes équipées d'une cible de chrome sur laquelle on applique une densité de puissance de 5 W/cm². Une couche de carbure de tungstène est ensuite élaborée par pulvérisation d'une cathode magnétron plane pour obtenir une épaisseur de 1,5 µm. Pour cela, la seconde cathode est équipée d'une cible en carbure de tungstène, sur laquelle on applique une densité de puissance de 5 W/cm². Ensuite, de l'acétylène est introduit à débit croissant pour obtenir une couche apte à l'accroche du DLC. Enfin, le DLC est déposé dans une atmosphère d'acétylène en polarisant la chemise à -500V sous une pression de 1 Pa, pour obtenir une épaisseur de 2,2 µm.

Il résulte de ces opérations un dépôt de type DLC à l'intérieur de la chemise, qui se caractérise par une adhérence par indentation Rockwell, notée HF1 à HF2. L'épaisseur du dépôt, déterminée par calotest, indique que la sous-couche a une épaisseur de 1,7 µm (0,2+1,5) et le DLC une épaisseur de 2,2 µm.

Dans un cinquième mode de réalisation, deux chemises moteur en acier, destinées à la compétition automobile, de 92 mm de diamètre et 80 mm de long ont été revêtues de DLC. La surface interne de l'une des chemises a été préalablement polie par technique de type tribofinition, de sorte que le Ra soit inférieur à 0,06 µm. La deuxième chemise moteur a subit une opération de honing, telle que réalisée selon l'état de l'art, son Ra est de 0,25 µm.

Après nettoyage, les chemises ont été placées dans une enceinte à vide. Pendant le pompage, la chambre à vide et les chemises sont dégazées de façon conventionnelle par chauffage radiatif à 200°C. Lorsque le vide a atteint une pression de l'ordre de 1×10⁻⁵ mbar, de l'argon a été introduit dans la chambre à vide pour obtenir une pression de 0,3 Pa, les chemises ont été portées à une tension négative de -150 V dans un plasma généré par des sources micro-ondes positionnées en parois de la machine pour effectuer un décapage ionique, permettant d'éliminer l'oxyde naturel recouvrant l'acier pour favoriser l'adhérence du revêtement. Pendant tout le traitement, les chemises se déplacent dans la machine selon un mouvement planétaire afin d'être exposées aux différentes sources de plasma. Après décapage, un dépôt de type carbure de tungstène a été effectué à l'intérieur de la chemise en utilisant une cathode magnétron plane en parois de l'équipement de dépôt. La cible plane est composée de carbure de tungstène et on y applique une densité de puissance de 5 W/cm² pour faire le dépôt. En cours de dépôt de carbure de tungstène, de l'acétylène a été introduit à débit croissant de sorte que la structure du dépôt évolue d'un carbure de tungstène à une matrice de carbone amorphe incluant du tungstène. Enfin, la couche de carbone amorphe de type DLC est déposée en portant la pièce à une tension de -380V dans une atmosphère d'acétylène à une pression de 0,4 Pa. Le plasma est généré par les sources micro-ondes positionnées en parois de la machine.

Il résulte de ces opérations un dépôt de type DLC à l'intérieur de chaque chemise, qui se caractérise par une adhérence par indentation Rockwell, notée HF1 à HF2. L'épaisseur du dépôt, déterminée par calotest, indique que la sous-couche a une épaisseur de 1,7 µm et le DLC une épaisseur de 2,5 µm .

A l'issue des différents traitements, une bande de 10 mm de large a été découpée selon la longueur de la chemise pour caractériser les revêtements sur le plan tribologique.

Pour ces tests, un tribomètre linéaire alternatif a été utilisé. Une bille en acier revêtue d'un dépôt de CrN ou d'un revêtement de DLC a été utilisée pour effectuer le test de frottement face aux différentes portions de chemises. Les billes ont subi un revêtement classique de CrN par PVD (pulvérisation cathotique magnétron) si ce n'est que l'épaisseur du dépôt était de 15 µm afin d'être représentative d'une couche déposée sur segment. De même, le revêtement des billes acier par du DLC, comporte une sous-couche de Cr pur PVD de 1 µm d'épaisseur puis une couche PVD à base de carbure de tungstène présentant un enrichissement en carbone en s'éloignant de la surface de l'acier, d'épaisseur 3 µm. Enfin, la couche de DLC a été élaborée par PECVD, son épaisseur est de 6 µm, ce qui conduit à une épaisseur totale de revêtement de 10 µm. Un témoin plan poli de Ra initial 0,02 µm a été revêtu de DLC simultanément aux billes. Après dépôt, la rugosité sur ce témoin plan est passée à 0,08 µm. Cette augmentation de rugosité est induite par l'épaisseur du revêtement.

Une charge de 5N est appliquée sur la bille, ce qui résulte en une pression moyenne initiale de contact de 540 MPa. La bille effectue un mouvement de glissement alternatif contre les portions de chemises, à une vitesse moyenne de 35 mm/s. La vitesse évolue selon une loi sinusoïdale obtenue par un excentrique. La longueur de la course est de 10 mm. Pour ces essais, une goutte d'huile moteur, de type SAE 5W30, est introduite dans le contact. Les tests sont conduits à une température de 110°C. Au bout de 15000 cycles, le coefficient de frottement est relevé, ainsi que l'usure sur la bille et l'usure sur le morceau de chemise. L'usure sur la bille est quantifiée par mesure du diamètre de la trace de frottement, tandis que l'usure sur le morceau de chemise est quantifiée par profilométrie en travers de la trace de frottement. L'ensemble des paramètres choisis permet d'opérer en régime limite, correspondant au régime rencontré au voisinage du point mort haut et du point mort bas. Ce régime est responsable d'une grande partie des pertes par frottement et de l'usure des pièces en contact.

| N° essai | chemise | Ra chemise (µm) | N°exemple dépôt | bille | COF | Usure bille | Usure piste |
|---|---|---|---|---|---|---|---|
| 1 | honing | 0,11 | | CrN | 0,15 | 105 µm | N.M. |
| 2 | honing | 0,11 | | DLC | 0,10 | 100 µm | 3 µm |
| 3 | Polie + DLC | 0,02 | 1 | CrN | 0,11 | 110 µm | N.M. |
| 4 | Honing + DLC | 0,12 | 1 | CrN | 0,12 | 240 µm | N.M. |
| 5 | Polie + DLC | 0,04 | 2 | CrN | 0,11 | 120µm | N.M. |
| 6 | Polie + DLC | 0,04 | 2 | DLC | 0,06 | 110 µm | N.M. |
| 7 | Honing+ DLC | 0,12 | 2 | DLC | 0,09 | 180 µm | N.M. |
| 8 | Polie + DLC | 0,03 | 3 | CrN | 0,10 | 110 µm | N.M. |
| 9 | Honing + DLC | 0,11 | 3 | CrN | 0,11 | 230 µm | N.M. |
| 10 | Polie + DLC | 0,03 | 4 | CrN | 0,10 | 125 µm | N.M. |
| 11 | Honing + DLC | 0,12 | 4 | CrN | 0,11 | 220 µm | N.M. |
| 12 | Polie + DLC | 0,02 | 5 | CrN | 0,10 | 105µm | N.M. |
| 13 | Honing + DLC | 0,12 | 5 | CrN | 0,12 | 215µm | N.M. |

Dans l'essai n°1, on reproduit le comportement en régime limite du contact d'un segment revêtu nitrure de chrome face à une chemise réalisée suivant un moyen conventionnel. On constate que le coefficient de frottement est le plus élevé de l'ensemble des essais. La bille revêtue CrN ne s'use pas, le diamètre de frottement correspond à l'aire initiale de contact. L'examen de la bille montre également une coloration induite par la formation d'un film anti-usure sur la bille, induit par les additifs de l'huile.

Dans l'essai n°2, on reproduit le comportement d'un segment revêtu de DLC. Le revêtement de DLC permet une réduction du coefficient de frottement. Aucune usure n'est mesurable sur la bille. Par contre, on observe une usure sur la chemise. Cette usure est probablement induite par la dureté du dépôt sur la bille, combinée à sa rugosité.

On peut ensuite rassembler les résultats d'essais en 4 grandes catégories :
- chemise polie revêtue DLC / bille revêtue DLC (essais 6)
Dans cette configuration, le coefficient de frottement est particulièrement bas (0,06) et l'usure de la bille revêtue est négligeable. Cet exemple est conforme à l'utilisation dans un moteur.
- chemise polie revêtue DLC / bille revêtue CrN (essais 3, 5, 8, 10 et 12)

Dans cette configuration, le coefficient de frottement est de l'ordre de 0,10 à 0,11, il est plus bas que celui obtenu sans revêtement DLC. L'usure des nitrures de chrome est négligeable. On constate également que les additifs anti-usure de l'huile, ont réagi sur le nitrure de chrome et forment un film anti-usure. Cette série d'essais est conforme à l'invention.
- chemise avec état de surface de type honing revêtue DLC / bille revêtue DLC (essai 7)

Dans cette configuration, l'état de surface de la chemise est conservé tel qu'il est défini dans les chemises utilisées sans revêtement de DLC. Bien que les antagonistes soient du DLC comme dans l'essai 6, le coefficient de frottement est notablement plus élevé (0,09). On constate également que le dépôt de DLC sur la bille s'est usé de façon notable (180 µm). Cette configuration est non conforme à l'invention. La rugosité de la chemise associée à la présence d'un revêtement de DLC, ont conduit à une usure importante de l'antagoniste de la chemise représentant le segment.
- chemise avec état de surface de type honing revêtue DLC / bille revêtue CrN (essais 4, 9, 11 et 13)

Dans cette configuration, l'état de surface de la chemise est conservé tel qu'il est défini dans les chemises utilisées sans revêtement de DLC. Les coefficients de frottement sont de l'ordre de 0,11 à 0,12. Cette valeur est légèrement plus élevée que pour les essais 3, 5, 8, 10 et 12. Par contre, on note une usure assez importante sur les billes revêtues CrN, comprise entre 215 et 240 µm. Cette configuration est non conforme à l'invention. La rugosité de la chemise associée à la présence d'un revêtement de DLC, ont conduit à une usure excessive de l'antagoniste de la chemise.

Enfin, au travers de ces essais, il apparaît clairement que les sous-couches du DLC ou la méthode d'élaboration du revêtement n'influent pas de façon significative sur le résultat d'usure et de frottement.

Les avantages ressortent bien de la description, en particulier, on souligne et on rappelle que le remplacement de l'opération de honing de l'intérieur de la chemise par une opération de polissage et un revêtement DLC permet de minimiser l'usure du segment et de réduire les pertes par frottement et donc de réduire les émissions de CO₂ dans le cas d'un moteur à combustion, notamment dans le domaine de l'automobile.

## Revendications

1. Chemise de moteur à combustion interne ***caractérisée* en ce que** l'intérieur de la dite chemise est traité pour être totalement lisse et reçoit un revêtement du type DLC.

2. Chemise de moteur à combustion interne selon la revendication 1, ***caractérisée* en ce que** l'épaisseur du revêtement est inférieure à 10 µm.

3. Chemise de moteur à combustion interne selon la revendication 1, ***caractérisée* en ce que** l'épaisseur du revêtement est inférieure à 7 µm.

4. Chemise de moteur à combustion interne selon la revendication 1, ***caractérisée* en ce que** l'épaisseur du revêtement est inférieure ou égale à 4 µm.

5. Chemise de moteur à combustion interne selon l'une quelconque des revendications 1 à 4, ***caractérisée* en ce qu'**elle est réalisée dans un matériau de type métallique apte à subir une opération de polissage pour obtenir une faible rugosité.

6. Chemise de moteur à combustion interne selon l'une quelconque des revendications 1 à 5, ***caractérisée* en ce que** le revêtement DLC est appliqué à l'intérieur de la chemise polie par la technique de dépôt sous vide comportant une étape de décapage ionique et une étape correspondant au dépôt en tant que tel.

7. Chemise de moteur à combustion interne selon la revendication 1, ***caractérisée* en ce que** la valeur de la rugosité de la surface de la chemise avant dépôt, Ra est inférieure à 0,06 µm.

8. Chemise de moteur à combustion interne selon la revendication 1, ***caractérisée* en ce que** la valeur de la rugosité de la surface de la chemise avant dépôt, Ra est inférieure à 0,04 µm.
